# EUROPEAN PATENT SPECIFICATION

(11) **EP 2 827 691 B1**
(45) Date of publication and mention of the grant of the patent: **10.01.2018**
(21) Application number: 14169048.7
(22) Date of filing: 20.05.2014
(51) Int. Cl.: H05K 7/20

(54) **Cabinet for power electronic apparatus**
Gehäuse für leistungselektronische Vorrichtung
Armoire pour appareil électronique de puissance

(30) Priority: 16.07.2013 KR 20130083722
(43) Date of publication of application: 21.01.2015
(73) Proprietor: LSIS Co., Ltd., Anyang-si, Gyeonggi-do 431-848 (KR)
(72) Inventor: Ryoo, Seong Ryoul, 440-827 Gyeonggi-do (KR)
(74) Representative: Awapatent AB

(56) References cited:
- EP-A2- 2 469 996

## Description

### BACKGROUND OF THE DISCLOSURE

### 1. Field of the Disclosure

The present disclosure relates to a cabinet for an power electronic apparatus, and more particularly, to a cabinet for an power electronic apparatus, in which an oscillating capillary tube heat pipe unit connected to one portion of an heat dissipation plate cools down within a duct that is separated by a partition in an external case, thereby increasing cooling efficiency and at the same time preventing introduction of foreign materials.

### 2. Background of the Disclosure

Generally, a cabinet for an power electronic apparatus is broadly categorized into an outdoor type and an indoor type, depending on where it is installed. Various components are installed within either of the cabinet for an power electronic apparatus. When the various components operate, they generate a lot of heat. Therefore, the cabinet for an power electronic apparatus has to be equipped with a cooling system. Furthermore, foreign materials, such as water, salt, particles, and the like, are easily introduced into the outdoor-type cabinet for an power electronic apparatus. The outdoor-type cabinet for an power electronic apparatus in such an environment has to have construction to effectively prevent the introduction of the foreign material.

As technologies in the related art, heat dissipation construction for a communication apparatus cabinet is disclosed in Korean Laid-Open Patent Application No. 10-2007-0073906, and a cooling system for a case within which a communication apparatus is installed is disclosed in Korean Laid-Open Patent Application No. 10-2011-0080378.

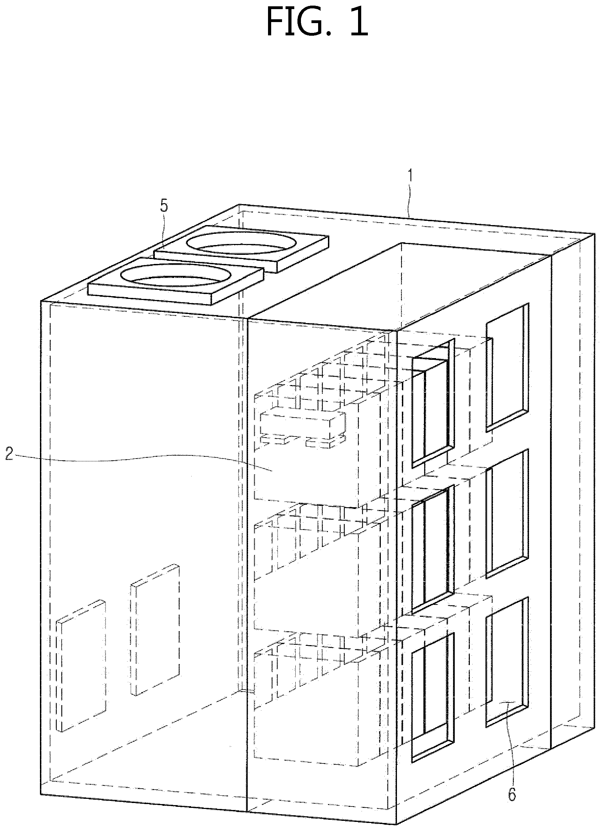

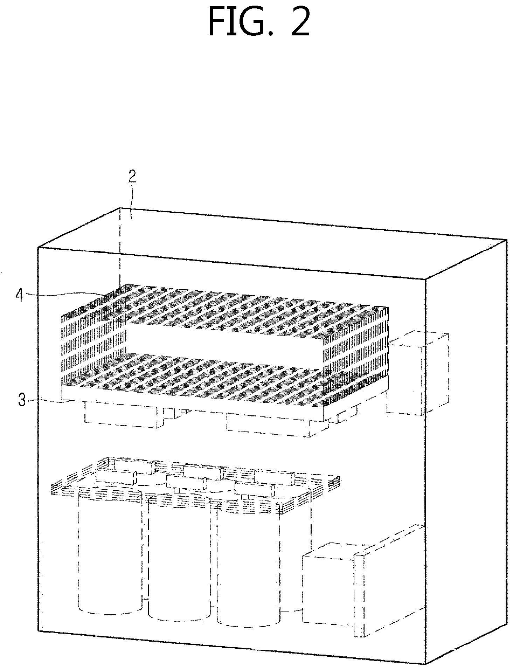

FIG. 1 is a perspective diagram illustrating an inverter cabinet as one example of a cabinet for an power electronic apparatus in the related art. FIG. 2 is a perspective diagram illustrating one portion of the inverter cabinet. Multiple inverter modules 2 are installed within a middle- or large-sized invert cabinet 1. In each inverter module 2, a lot of heat is generated from electronic components such as electric power semiconductor devices 3. In order to dissipate the heat, the inverter cabinet 1 has construction in which a heat sink 4 with heat dissipation fins is attached to one side of the electric power semiconductor device 3 and a fan 5 is installed on the outside of the cabinet 1. The inverter cabinet 1 operates as follows. When heat is generated from the multiple electric power semiconductor devices 3 installed within the inverter module 2, the fan 5 operates and thus cool outside air is introduced into the cabinet 1. At this point, foreign materials, such as water, salt, particles and the like, is filtered out through a filter attached to an intake hole 6, and thus contaminant-removed cool outside air cools down the multiple electric power semiconductor devices 3.

However, when the fan 5 is installed outside of the cabinet 1 in this manner, the fan 5 is difficult to waterproof and foreign materials is easily attached to the fan 5. This shortens the life of the fan 5 or causes a malfunction of the fan 5. Thus, a heat dissipation effect of the cabinet for an electric power electric apparatus is reduced. Accordingly, there is a problem in that the electronic components inside of the cabinet are easily damaged, and a cost of maintenance, such fan cleaning and fan replacement, is increased.

In addition, in such a convection-type cooling system, if outside air that is relatively considerably cool is introduced directly into the cabinet 1, ambient temperature in the vicinity of the electric or electronic components suddenly drops and causes dew condensation. Thus, in most cases, this makes it impossible for the internal components to operate properly. If to prevent this, a heating unit is additionally installed, there is a problem in that the construction of the cabinet becomes complex and power consumption increases.

On the other hand, since cool outside air introduced into the cabinet cools down the internal components, moisture included in the outside air and foreign materials including fine dust comes into direct contact with the internal electric power semiconductor devices. Thus, dust gathers on the internal electric power components and this causes a problem, such as a malfunction.

EP 2 469 996 A2 discloses power semiconductor modules placed on one side of a heat receiving member. The power semiconductor modules are sealed in a case. Heat receiving portions of U-shaped heat pipes are embedded in the heat receiving member on the side opposite to the side where the power semiconductor modules are placed. Heat dissipating portions as two end parts of each U-shaped heat pipe extend upward from the heat receiving member. A cover is provided on the heat pipe side. Air taken in through openings at a lower part of the cover flows upward by natural convection and is discharged through openings at an upper part of the cover.

### SUMMARY OF THE DISCLOSURE

Therefore, an aspect of the detailed description is to provide a cabinet for an power electronic apparatus, and more particularly to a cabinet for an power electronic apparatus, in which an oscillating capillary tube heat pipe unit connected to one portion of an heat dissipation plate cools down within a duct that is separated by a partition in an external case, thereby increasing cooling efficiency and at the same time preventing introduction of foreign materials.

To achieve these and other advantages and in accordance with the purpose of this specification, as embodied and broadly described herein, there is provided a cabinet for an power electronic apparatus, including: an external case that accommodates a module accommodation unit; a duct that is formed as a section divided in one side wall of the external case; an intake hole that is formed in the lower portion of the duct; a circulation fan that is provided in the upper portion of the duct; a heat dissipation plate that is fastened to one side of an power electronic module that is accommodated in the module accommodation unit; and an oscillating capillary tube heat pipe unit that is mounted on the heat dissipation plate. In particular, there is provided a cabinet in accordance with the independent claim. Embodiments are given by the dependent claims.

In the cabinet for an power electronic apparatus, the oscillating capillary tube heat pipe unit may be formed in a bent manner, and may pass through a mounting hole formed in a partition between the module accommodation unit and the duct, and a heat dissipation portion of oscillating capillary tube heat pipe unit may stay within the duct and a heat-absorbing portion of the oscillating capillary tube heat pipe unit may be connected to the heat dissipation plate.

In the cabinet for an power electronic apparatus, a hermetic seal may be provided to remove section between the mounting hole and the oscillating capillary tube heat pipe unit.

In the cabinet for an power electronic apparatus, the module accommodation unit may be separated, by the duct, from outside air and foreign materials are not introduced into the module accommodation unit.

In the cabinet for an power electronic apparatus, a filter may be provided to the intake hole. In the cabinet for an power electronic apparatus, the duct may be separately manufactured and is separated from or is attached to the external case.

In the cabinet for an power electronic apparatus according to one embodiment of the present invention, cooling is provided using both conductivity and convection, and a phase-change cooling method that uses the oscillating capillary tube heat pipe unit. This brings about an effect of increasing cooling efficiency. In addition, with the construction in which the heat dissipation unit of the heat pipe is exposed to the duct that is formed as a section divided in one side wall of the external case, external air is not introduced into the module accommodation unit. This brings about an effect of the internal electronic components being not exposed to foreign materials or dust. In addition, because external air does not come into direct contact with the power electronic module or the heat dissipation plate, this brings about an effect of preventing a sudden change in temperature and dew condensation. On the other hand, because the circulation fan is not exposed to the atmosphere, this reduces a likelihood of contamination and damage and decreases a maintenance cost.

Further scope of applicability of the present application will become more apparent from the detailed description given hereinafter. However, it should be understood that the detailed description and specific examples, while indicating preferred embodiments of the disclosure, are given by way of illustration only, since various changes and modifications within the spirit and scope of the disclosure will become apparent to those skilled in the art from the detailed description.

### BRIEF DESCRIPTION OF THE DRAWINGS

The accompanying drawings, which are included to provide a further understanding of the disclosure and are incorporated in and constitute a part of this specification, illustrate exemplary embodiments and together with the description serve to explain the principles of the disclosure.

In the drawings:
FIG. 1 is a perspective diagram illustrating a cabinet for an power electronic apparatus in the related art;
FIG. 2 is a perspective diagram illustrating one portion of the cabinet for an power electronic apparatus in the related art;
FIG. 3 is a perspective diagram illustrating a cabinet for an power electronic apparatus according to the present invention;
FIG. 4 is a side diagram illustrating the cabinet for an power electronic apparatus according to the present invention;
FIG. 5 is a perspective diagram illustrating one portion of the cabinet for an power electronic apparatus according to the present invention;
FIGS. 6A and 6B are perspective diagrams illustrating a heat dissipation plate in FIG. 3; and
FIG. 7 is a perspective diagram illustrating a duct in FIG. 3.

### DETAILED DESCRIPTION OF THE DISCLOSURE

Description will now be given in detail of the exemplary embodiments, with reference to the accompanying drawings. For the sake of brief description with reference to the drawings, the same or equivalent components will be provided with the same reference numbers, and description thereof will not be repeated.

Embodiments of the present invention are described in detail below referring to the drawings. This is done in order for a person of ordinary skill in the art to reduce the present invention to practice without undue experimentation. However, this does not impose any limitation to the nature and gist and the scope of the present invention.

A cooling apparatus in a cabinet for an power electronic apparatus according to one embodiment of the present invention is configured to include an external case 10, a duct 15 that is formed as a section divided in one side wall of the external case, an intake hole 16 that is formed in the lower portion of the duct, a circulation fan 17 that is provided in the upper portion of the duct 15, a heat dissipation plate 30 that is fastened to one side of an power electronic module 20 that is accommodated in the module accommodation unit 11, and an oscillating capillary tube heat pipe unit 35 that is mounted on the heat dissipation plate 30.

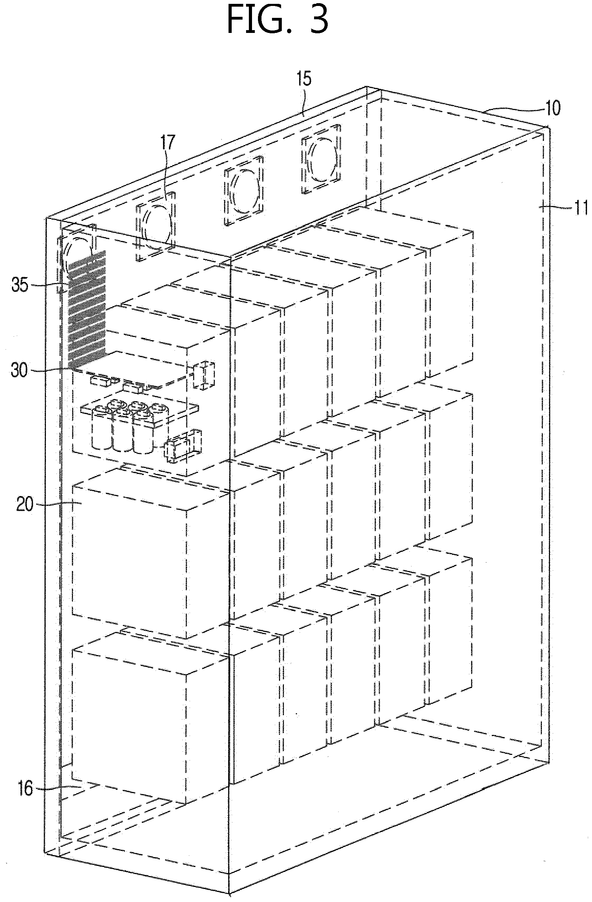

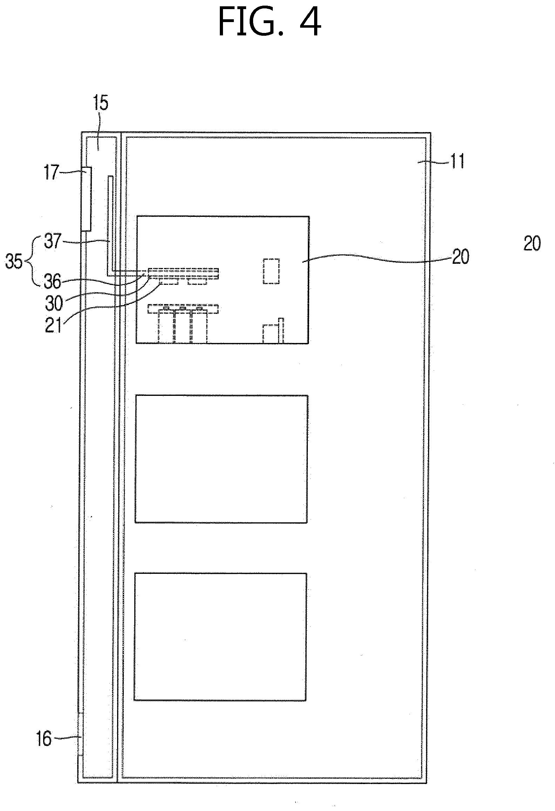

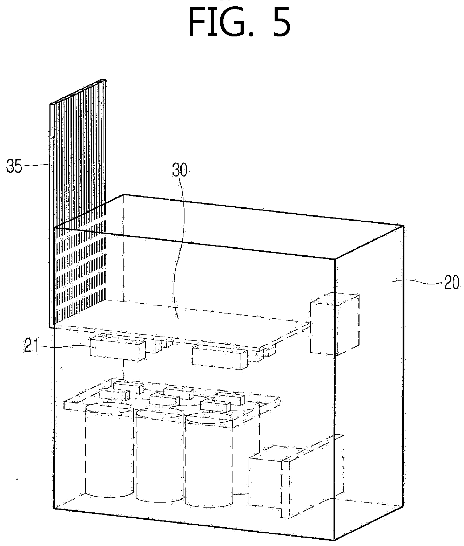

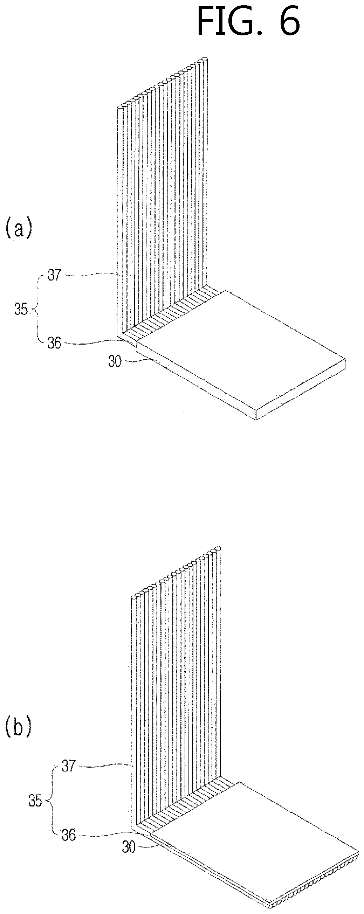

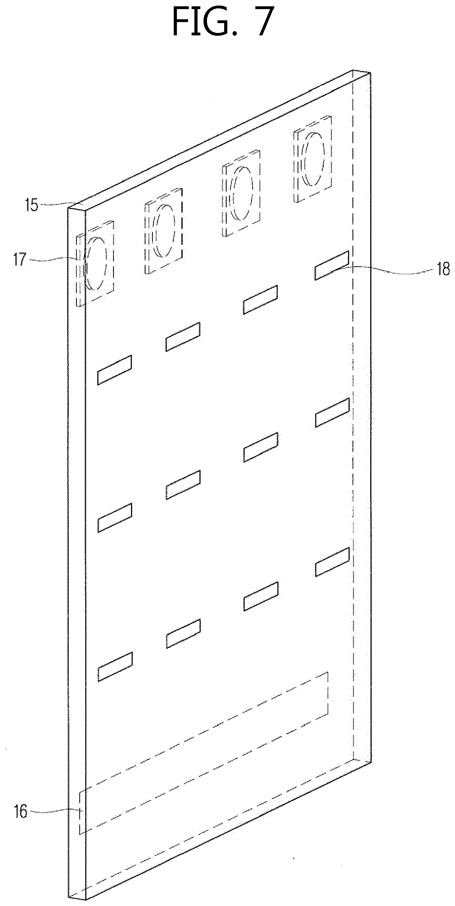

FIG. 3 is a perspective diagram illustrating the cabinet for an power electronic apparatus according to the present invention. FIG. 4 is a side diagram illustrating the cabinet for an power electronic apparatus according to the present invention. FIG. 5 is a perspective diagram illustrating one portion of the cabinet for an power electronic apparatus according to the present invention, FIGS. 6A and 6B are perspective diagrams illustrating a heat dissipation plate. FIG. 7 is a perspective diagram illustrating a duct. One embodiment of the present invention is described in detail referring to the drawings.

The external case 10 is configured to make up a main body of the cabinet for an power electronic apparatus. The external case 10 takes on a shape of a hexahedral case. The external case 10 are made of materials such as iron or synthetic resin. The external case 10 is properly designed considering a property, a size, a weight, strength, and the like of each component accommodated inside.

The external case 10 is divided by the module accommodation unit 11 and the duct 15. The module accommodation unit 11 accommodates the power electronic modules 20. The duct 15 is for dissipating heat. Outside air is introduced and exhausted through the duct 15. The outside air circulates to pick up and carry away the heat. A partition inside of the module accommodation unit 11 separates the module accommodation unit 11 and the duct 15 from each other. According to another embodiment, as illustrated in FIG. 7, the duct 15 is separately manufactured and is attached to one side of the external case 10.

The intake hole 16 is formed in the lower portion of the duct 15. The intake hole 16 takes on a rectangular shape that runs in a transverse direction of the duct 15. The width of the intake hole 16 is properly designed in a manner that takes in the outside air. A filter (not illustrated) is attached to the intake hole 16 to filter out contaminants, particles, and the like contained in the outside air.

The circulation fan 17 is installed in the upper portion of the duct 15. The circulation fan 17 is installed in a manner that is not exposed to outside of the external case 10. Thus, only the outgoing outside air from the circulation fan 17 is exhausted to the atmosphere through a fan hole formed in the duct 15. The proper number of the circulation fans 17 that are to be installed depends on their capacities.

The circulation fan 17 in the duct 15 forces the air to flow upwards by convection. Thus, outside air is introduced, through the intake hole 16 in the lower portion of the duct 15, into the duct 15. Then, the outside air flows through the duct 15 and is exhausted back to the atmosphere through the fan hole in the upper portion of the duct 15.

Multiple mounting holes 18 are formed in the partition between the duct 16 and the module accommodation unit 11. Multiple oscillating capillary tube heat pipe unit 35 described below passes through the multiple mounting holes 18, respectively.

The power electronic module 20 is installed in the module accommodation portion 11. Generally, the multiple power electronic modules 20 are installed in a middle- or large-sized power electronic cabinet. The power electronic module 20 according to one embodiment, as illustrated in FIG. 3, is configured from inverters. A PCB on which heat-generating elements 21 and the like are mounted is installed in the power electronic module 20. A heat dissipation plate 30 for dissipating heat that is generated from the heat-generating elements is installed in the power electronic module 20.

The heat dissipation plate 30 is mounted on one side of the heat-generating element 21 in order to dissipate the heat from the heat-generating element 21. The heat dissipation plate 30 is mounted in a manner that corresponds to multiple heat-generating elements 21. The heat dissipation plate 30 is formed in a shape of a plate in order to accomplish the ease with which to install the heat dissipation plate 30 and to accomplish a large cooling effect. The heat dissipation plate 30 is fastened to the power electronic module 20 using screws and the like, but may be fastened to the power electronic module 20 using a bonding agent instead of a separate component in order to prevent a heat-localizing phenomenon and the like and thus maximize the cooling effect.

The oscillating capillary tube heat pipe unit 35 is attached to the heat dissipation plate 30. The oscillating capillary tube heat pipe unit 35, as known in the related art, dissipates latent heat by using a change in the phase of a charged material. The oscillating capillary tube heat pipe is excellent in thermal conductivity, thereby accomplishing a large thermal transfer effect. For example, whereas thermal conductivity of an aluminum plate is on the order of 220 W/m.°C, thermal conductivity of the oscillating capillary tube heat pipe is approximately 10,000 W/m.°C. Accordingly, 50 times a heat dissipation effect of the aluminum plate is accomplished.

A heat-absorbing portion 36 of the oscillating capillary tube heat pipe unit 35 is attached to the heat dissipation plate 30. This is done by using an jointing or welding method. According to another embodiment, the heat-absorbing portion 36 may be inserted into the heat dissipation plate 30 for connection. FIGS. 6A illustrate an example in which the heat-absorbing portion 35 is inserted into the heat dissipation plate 30, according to one embodiment. FIGS. 6B illustrates an example in which the heat-absorbing portion 35 is attached to the heat dissipation plate 30, according to one embodiment.

A heat dissipation portion 37 of the oscillating capillary tube heat pipe unit 35 is formed in a manner that extends from one end of the heat-absorbing portion 36 at a given angle with respect to the heat-absorbing portion 35. The heat-absorbing portion 36 of the oscillating capillary tube heat pipe unit 35 passes through the mounting hole 18 formed in the partition between the module accommodation portion 11 and the duct 15, and is inserted into the power electronic module 20 in a penetrating manner in order to connect to the heat-generating element 21. In contrast, the heat dissipation portion 37 of the oscillating capillary tube heat pipe unit 35 stays inside of the duct 15 and thus is exposed to outside air.

At this point, a hermetic seal is provided to remove section between the mounting hole 18 and the oscillating capillary tube heat pipe unit 35. Accordingly, the module accommodation portion 11 is separated from outside air and thus remains airtight, forming section inside.

The heat dissipation portion 37 is exposed to the duct 15 that is formed as a section divided in one side wall of the external case 10 or that is separately manufactured and is attached to one side of the external case 10. This brings about an effect of preventing particles and the like in outside air from being introduced into the module accommodation portion 11. Furthermore, external air does not comes into direct contact with the power electronic module 20. This brings about an effect of preventing from temperature inside of the power electronic module 20 from suddenly changes and from dew condensation to occur in the power electronic module 20.

In addition, the circulation fan 17 is not exposed to the atmosphere. This reduces contamination of and damage to the circulation fan 17, thereby decreasing a maintenance cost.

The foregoing embodiments and advantages are merely exemplary and are not to be considered as limiting the present disclosure. The present teachings can be readily applied to other types of apparatuses. This description is intended to be illustrative, and not to limit the scope of the claims. Many alternatives, modifications, and variations will be apparent to those skilled in the art. The features, structures, methods, and other characteristics of the exemplary embodiments described herein may be combined in various ways to obtain additional and/or alternative exemplary embodiments.

As the present features may be embodied in several forms without departing from the characteristics thereof, it should also be understood that the above-described embodiments are not limited by any of the details of the foregoing description, unless otherwise specified, but rather should be considered broadly within its scope as defined in the appended claims, and therefore all changes and modifications that fall within the metes and bounds of the claims, or equivalents of such metes and bounds are therefore intended to be embraced by the appended claims.

## Claims

1. A cabinet for an power electronic apparatus, comprising:
an external case (10) that accommodates a module accommodation unit (11);
a duct (15) that is formed in one side wall of the external case (10);
an intake hole (16) that is formed in the lower portion of the duct (15);
a circulation fan (17) that is provided in the upper portion of the duct (15); and
a heat dissipation plate (30) that is fastened to one side of an power electronic module that is accommodated in the module accommodation unit (11);
**characterized in that**:
an oscillating capillary tube heat pipe unit (35) that is mounted on the heat dissipation plate (30),
wherein the oscillating capillary tube heat pipe unit (35) is formed in a bent manner, and passes through a mounting hole (18) formed in a partition between the module accommodation unit (11) and the duct (15), and
wherein a heat dissipation portion (37) of oscillating capillary tube heat pipe unit (35) stays within the duct (15) and a heat-absorbing portion (36) of the oscillating capillary tube heat pipe unit (35) is connected to the heat dissipation plate (30).

2. The cabinet for an power electronic apparatus according to claim 1, wherein a hermetic seal is provided between the mounting hole (18) and the oscillating capillary tube heat pipe unit (35).

3. The cabinet for an power electronic apparatus according to any of preceding claims, wherein the module accommodation unit (11) is separated, by the duct (15), from outside air and foreign materials are not introduced into the module accommodation unit (11).

4. The cabinet for an power electronic apparatus according to any of preceding claims, wherein a filter is provided to the intake hole (16).

5. The cabinet for an power electronic apparatus according to any of preceding claims, wherein the duct (15) is separately manufactured and is separated from or is attached to the external case (10).

## Patentansprüche

1. Gehäuse für eine leistungselektronische Vorrichtung, umfassend:
einen äußeren Kasten (10), der eine Modulaufnahmeeinheit (11) aufnimmt;
einen Kanal (15), der in einer Seitenwand des äußeren Kastens (10) ausgebildet ist;
eine Einlassöffnung (16), die in dem unteren Abschnitt des Kanals (15) ausgebildet ist;
einen Ventilator (17), der in dem oberen Abschnitt des Kanals (15) vorgesehen ist; und
eine Wärmeableitplatte (30), die an einer Seite eines leistungselektronischen Moduls befestigt ist, das in der Modulaufnahmeeinheit (11) aufgenommen ist;
**dadurch gekennzeichnet, dass**:
eine als schwingendes Kapillarrohr ausgeführte Wärmerohreinheit (35), die an der Wärmeableitplatte (30) installiert ist,
wobei die als schwingendes Kapillarrohr ausgeführte Wärmerohreinheit (35) gebogen ausgebildet ist und durch eine Installationsöffnung (18) verläuft, die in einer Trennwand zwischen der Modulaufnahmeeinheit (11) und dem Kanal (15) ausgebildet ist, und
wobei ein Wärmeableitabschnitt (37) der als schwingendes Kapillarrohr ausgeführten Wärmerohreinheit (35) innerhalb des Kanals (15) verbleibt und ein Wärmeabsorptionsabschnitt (36) der als schwingendes Kapillarrohr ausgeführten Wärmerohreinheit (35) mit der Wärmeableitplatte (30) verbunden ist.

2. Gehäuse für eine leistungselektronische Vorrichtung nach Anspruch 1, wobei zwischen der Installationsöffnung (18) und der als schwingendes Kapillarrohr ausgeführten Wärmerohreinheit (35) eine hermetische Dichtung vorgesehen ist.

3. Gehäuse für eine leistungselektronische Vorrichtung nach einem der vorhergehenden Ansprüche, wobei die Modulaufnahmeeinheit (11) durch den Kanal (15) von der Außenluft getrennt ist und keine Fremdmaterialien in die Modulaufnahmeeinheit (11) eingebracht werden.

4. Gehäuse für eine leistungselektronische Vorrichtung nach einem der vorhergehenden Ansprüche, wobei für die Einlassöffnung (16) ein Filter vorgesehen ist.

5. Gehäuse für eine leistungselektronische Vorrichtung nach einem der vorhergehenden Ansprüche, wobei der Kanal (15) separat hergestellt wird und von dem äußeren Kasten (10) getrennt oder an diesem angebracht ist.

## Revendications

1. Armoire pour un dispositif électronique de puissance, comprenant :
un boîtier externe (10) qui renferme une unité de logement de module (11);
une conduite (15) qui est formée dans une paroi latérale du boîtier externe (10);
un trou d'admission (16) qui est formé dans la portion inférieure de la conduite (15);
un ventilateur de circulation (17) qui est prévu dans la portion supérieure de la conduite (15) ; et
une plaque de dissipation thermique (30) qui est fixée à un côté d'un module électronique de puissance qui est renfermé dans l'unité de logement de module (11);
**caractérisé en ce que** :
une unité de tube caloduc capillaire oscillant (35) qui est montée sur la plaque de dissipation thermique (30) ;
dans laquelle l'unité de tube caloduc capillaire oscillant (35) est formé d'une manière incurvée et passe à travers un trou de montage (18) formé dans une partition entre l'unité de logement de module (11) de la conduite (15) et
dans lequel une portion de dissipation thermique (37) de l'unité de tube caloduc capillaire oscillant (35) reste à l'intérieur de la conduite (15) et
une portion d'absorption thermique (36) de l'unité de tube caloduc capillaire oscillant (35) est raccordée à la plaque de dissipation thermique (30).

2. Armoire pour un dispositif électronique de puissance selon la revendication 1, dans lequel un joint d'étanchéité hermétique est prévu entre le trou de montage (18) et l'unité de tube caloduc capillaire oscillant (35).

3. Armoire pour un dispositif électronique de puissance selon une quelconque des revendications précédentes, dans lequel l'unité de logement de module (11) est séparée, par la conduite (15), de l'air extérieur et des matériaux étrangers ne sont pas introduits dans l'unité de logement de module (11).

4. Armoire pour un dispositif électronique de puissance selon une quelconque des revendications précédentes, dans lequel un filtre est fourni dans le trou d'admission (16).

5. Armoire pour un dispositif électronique de puissance selon une quelconque des revendications précédentes, dans lequel la conduite (15) est fabriquée séparément et est séparée de ou fixée au boîtier externe (10).
